(19) Europäisches Patentamt

European Patent Office

Office européen des brevets

(11) **EP 1 019 704 B1**

(12) **FASCICULE DE BREVET EUROPEEN**

(45) Date de publication et mention
de la délivrance du brevet:
**28.05.2003 Bulletin 2003/22**

(21) Numéro de dépôt: **98946533.1**

(22) Date de dépôt: **30.09.1998**

(51) Int Cl.⁷: **G01N 21/47**

(86) Numéro de dépôt international:
**PCT/FR98/02092**

(87) Numéro de publication internationale:
**WO 99/017099 (08.04.1999 Gazette 1999/14)**

(54) **DETECTEUR OPTIQUE ACTIF**

AKTIVER OPTISCHER DETEKTOR

ACTIVE OPTICAL DETECTOR

(84) Etats contractants désignés:
**BE CH DE ES FR GB IT LI LU NL**

(30) Priorité: **30.09.1997 FR 9712391**

(43) Date de publication de la demande:
**19.07.2000 Bulletin 2000/29**

(73) Titulaire: **UNIVERSITE JOSEPH FOURIER
F-38041 Grenoble Cédex (FR)**

(72) Inventeurs:
• **LACOT, Eric
F-38400 Saint Martin d'Hères (FR)**
• **STOECKEL, Frédéric
F-38410 Uriage (FR)**

(74) Mandataire: **de Beaumont, Michel
1, rue Champollion
38000 Grenoble (FR)**

(56) Documents cités:
**DE-A- 2 852 614       US-A- 4 243 320
US-A- 5 272 708**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention concerne un détecteur optique et plus particulièrement un détecteur optique actif émettant un faisceau lumineux dans une zone à étudier et analysant la lumière renvoyée ou transmise par cette zone.

Un objet plus particulier de la présente invention est de prévoir un tel détecteur qui fonctionne même quand une zone d'un milieu à étudier renvoie ou transmet seulement une très faible partie de la lumière reçue.

Ainsi, la présente invention s'applique en particulier à la détection d'obstacles ou d'interfaces dans des milieux diffusants, par exemple des milieux organiques.

La présente invention vise les cas où la lumière réémise est difficilement détectable par des procédés classiques utilisant par exemple des systèmes de hacheur et de détection synchrone.

La présente invention prévoit de réinjecter dans un laser une lumière réémise à une fréquence décalée par rapport à la fréquence d'émission du laser, en utilisant un type de laser spécifique, à savoir un laser de classe B qui, quand on y réinjecte de la lumière à une fréquence décalée d'une valeur correspondant sensiblement à une fréquence propre ou fréquence de relaxation de ce laser, produit un faisceau laser modulé, l'amplitude de la modulation correspondant à un facteur de l'ordre de $10^3$ à $10^6$ par rapport à une détection hétérodyne classique.

Plus particulièrement, la présente invention prévoit un détecteur optique comprenant une source laser de classe B émettant un faisceau à une première fréquence optique ; un moyen interagissant avec le faisceau pour fournir un rayonnement à fréquence optique modifiée, le décalage entre la première fréquence et la fréquence modifiée étant voisin d'une fréquence de relaxation du laser ; un moyen pour irradier une zone choisie d'un milieu à étudier par le rayonnement à la fréquence modifiée ; un moyen pour injecter dans le laser de la lumière renvoyée par la zone choisie ; et un moyen pour détecter la perturbation apportée à l'émission laser par la lumière réinjectée.

Selon un mode de réalisation de la présente invention, ce détecteur comprend des moyens de balayage de la zone à étudier.

Selon un mode de réalisation de la présente invention, ce détecteur comprend des moyens de balayage en fréquence du rayonnement émis par le laser.

Selon un mode de réalisation de la présente invention, le moyen d'irradiation est constitué d'un objectif.

Selon un mode de réalisation de la présente invention, le moyen de détection comprend un photodétecteur suivi d'un système à détection synchrone.

Selon un mode de réalisation de la présente invention, le moyen pour fournir un rayonnement à fréquence optique modifiée consiste en un milieu possédant un effet électro-optique ou acousto-optique excité par un oscillateur à une fréquence correspondant à la différence entre la fréquence optique modifiée et la première fréquence optique ou un de ses sous-multiples.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 représente schématiquement et sous forme de blocs un premier mode de réalisation de la présente invention ;
la figure 2 représente schématiquement et sous forme de blocs un deuxième mode de réalisation de la présente invention ; et
la figure 3 représente schématiquement et sous forme de blocs un troisième mode de réalisation de la présente invention.

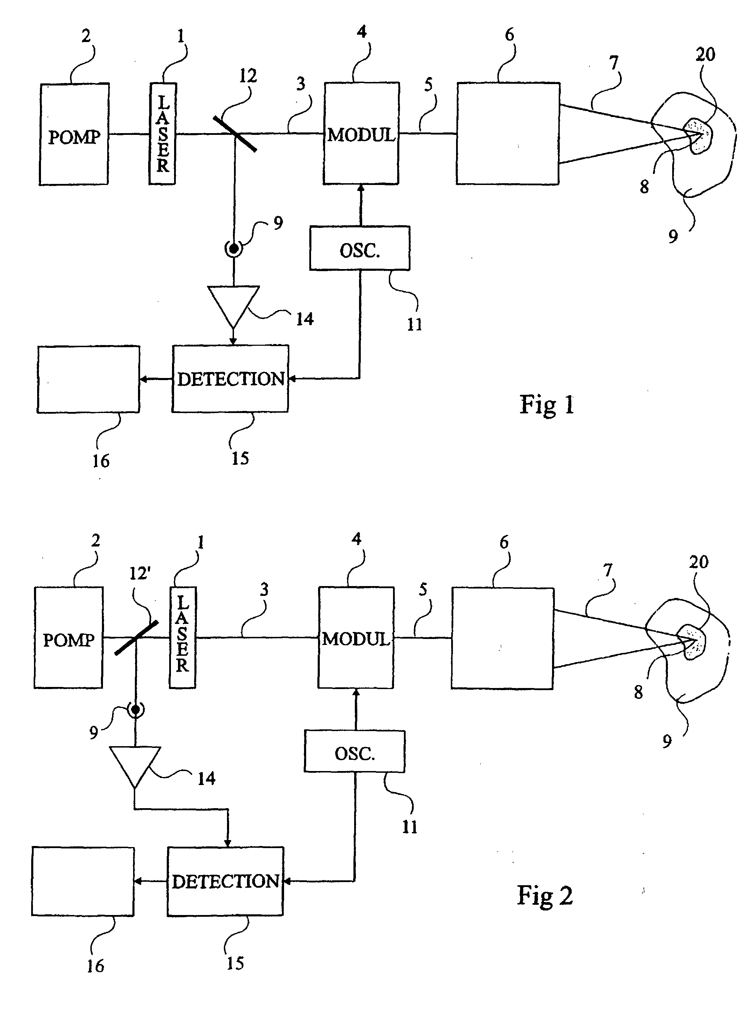

Comme le représente la figure 1, la présente invention utilise un laser 1 de classe B pompé optiquement ou électriquement. Dans le mode de réalisation représenté, on utilise un pompage optique symbolisé par une pompe optique 2. Le faisceau 3 émis par le laser traverse un modulateur optique 4 qui a pour effet de fournir en sortie un faisceau laser 5 comprenant au moins une partie de l'énergie incidente décalée en fréquence d'une fréquence F et/ou d'un ou plusieurs de ses multiples entier. Le faisceau laser 5 avec sa ou ses fréquences décalées est envoyé sur un système optique 6 qui fournit un faisceau 7 réorienté et focalisé en un point 8 d'un milieu 9. La lumière en retour réémise par réflexion et/ou rétrodiffusion à partir du point de focalisation est retransformée par l'objectif 6 en un faisceau qui retourne dans le laser 1 dont le fonctionnement est affecté d'une façon qui sera exposée ci-après.

Le modulateur 4 est commandé par un oscillateur 11 fonctionnant à une fréquence F. Une partie du faisceau émis par le laser est renvoyé par une séparatrice 12 vers un photodétecteur 13 suivi de préférence d'un amplificateur 14 dont on détecte la sortie de préférence par un circuit de détection synchrone 15 qui permet la détection du signal reçu à la fréquence F (et/ou à un multiple de cette fréquence). Le détecteur synchrone 15 est relié à un dispositif de fourniture d'information 16, par exemple un système d'affichage.

Le fonctionnement du détecteur selon la présente invention se base comme on l'a indiqué précédemment sur l'utilisation d'un laser de classe B. Un tel laser, dont la définition scientifique est qu'il s'agit d'un laser pour lequel la durée de vie de l'inversion de population du milieu amplificateur est plus grande que la durée de vie de la cavité laser, peut être un laser à semiconducteur ou un laser à solide.

Le laser peut être équipé d'un ou plusieurs éléments optiques qui permettent une sélection et/ou un balayage de la ou des fréquences optiques. Le laser peut émettre une seule fréquence optique (laser monomode) ou plusieurs fréquences optiques (laser multimode). L'émission du laser peut être polarisée ou non. Ce laser peut être pompé par un laser dit de pompe si le pompage doit être optique. Le pompage peut aussi être électrique comme c'est le cas généralement pour les lasers à semiconducteurs. La plage des fréquences optiques émise par le laser 2 est adaptée aux réponses optiques des milieux à analyser ou à détecter.

Un laser de classe B présente la particularité que, quand on y réinjecte de la lumière à une fréquence modifiée décalée d'une fréquence F (ou d'un multiple d'une fréquence F) proche d'une fréquence propre ou fréquence de relaxation du laser, il se produit une modulation de l'intensité lumineuse à la fréquence F. Ceci équivaut à une amplification de la puissance réinjectée d'un facteur qui peut, selon le laser, et selon le réglage de la fréquence de décalage être de l'ordre de $10^3$ à $10^6$.

Le décaleur de fréquence optique 4 permet de générer à partir d'un faisceau lumineux émis par le laser à une fréquence optique, dite fréquence porteuse, un ou plusieurs faisceaux optiques 5 à une ou plusieurs fréquences optiques décalées en fréquence. Ce décalage en fréquence se fait à une fréquence F et/ou à ses multiples entiers. Le décalage en fréquence peut être positif et/ou négatif.

Le décalage de la fréquence optique peut se faire à l'aide d'une modulation d'amplitude ou d'une modulation de fréquence ou de phase de l'onde émise par le laser. La modulation d'amplitude peut se faire à l'aide d'un modulateur possédant un effet électro-optique ou élasto-optique. La modulation de fréquence ou de phase peut se faire à l'aide d'un milieu possédant un effet électro-optique.

Un ou plusieurs de ces éléments optiques peuvent être mobiles ou permettre une déviation ou une translation du faisceau optique.

Le système optique peut inclure un ou plusieurs filtres optiques permettant de filtrer ou d'atténuer la lumière réinjectée dans le laser.

La séparatrice 12 a pour but de prélever une partie du faisceau 3 envoyé sur l'objet à mesurer pour la détourner vers un photodétecteur 13. On notera que cette séparatrice peut être sélective en fréquence optique ou en polarisation optique.

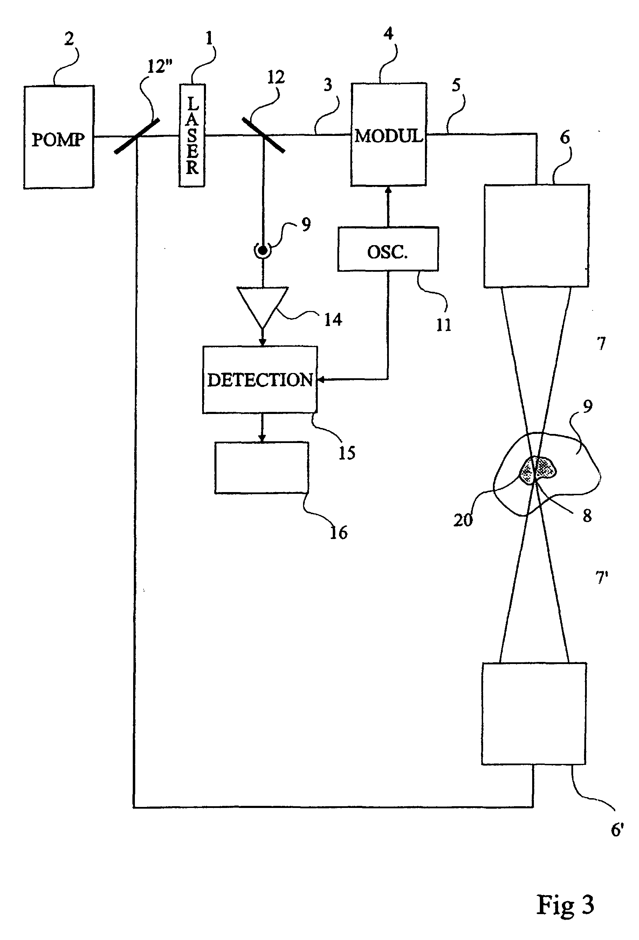

Les figures 2 et 3 représentent des variantes du dispositif de la figure 1. Dans ces variantes, de mêmes éléments sont désignés par de mêmes références.

La figure 2 représente un système très similaire à celui de la figure 1 mais dans lequel la séparatrice 12 (placée entre le laser et le modulateur 4 en figure 1) est remplacée par une séparatrice 12' placée de l'autre côté du laser, par exemple entre le laser et la pompe optique en figure 2.

La figure 3 représente une autre variante du système dans lequel le système à rétrodiffusion ou à réflexion de lumière est remplacé par un système à transmission. La lumière est envoyée vers le milieu étudié de la même façon que cela a été exposé précédemment par un laser 1, un modulateur 4 et un objectif 6. La lumière 7' ayant traversé le milieu est recueillie par un objectif 6' qui donne une image du point focal et cette lumière est réinjectée dans le laser par une séparatrice 12".

## UTILISATION DU DÉTECTEUR

On décrira plus particulièrement ci-après l'utilisation du détecteur selon la présente invention dans le mode par rétrodiffusion ou réflexion tel qu'illustré en relation avec les figures 1 et 2. L'homme de l'art pourra adapter sans difficultés ces explications au mode de fonctionnement par transmission tel qu'illustré en figure 3.

Si par exemple on cherche à identifier (voir figure 1) un corps 20 présentant avec un milieu diffusant 9 une interface dont le coefficient de diffusion/ réflexion est distinct de celui du milieu diffusant, on règle l'objectif 6 en distance jusqu'à ce que l'on observe un pic de lumière réémise et l'on sait alors que l'on se trouve au niveau de l'interface. On pourra prévoir divers moyens de décalage selon les directions x, y et z et en rotation pour fournir une image du corps 20.

Il peut également arriver que des interfaces ou des inhomogénéités d'un milieu présentent des variations de diffusion/réflexion particulièrement marquées à certaines longueurs d'onde. On pourra alors prévoir un laser 1 à longueur d'onde variable et modifier le réglage du laser pour s'adapter à la longueur d'onde au niveau de laquelle la détection est susceptible d'être plus élevée. Ceci pourra en particulier être utilisé pour détecter la présence ou l'absence d'un gaz dans un milieu, pour constituer par exemple un détecteur de fuite de gaz.

Bien entendu, la présente invention est susceptible de diverses variantes et modifications qui apparaîtront à l'homme de l'art. En particulier, le générateur de radiofréquence peut délivrer deux fréquences F1 et F2 et la démodulation peut se faire sur une combinaison de ces deux fréquences, par exemple F1 - F2.

D'autre part, les divers trajets optiques, notamment entre le laser 2 et l'objectif 6, peuvent se faire par fibres optiques et l'invention peut être adaptée à des systèmes de type endoscope.

La détection par réinjection sélective avec un laser de classe B peut être rendue multiplex en utilisant par exemple :

- plusieurs modules reliés par des fibres optiques au système optique 6 ;
- une barrette à une ou deux dimensions de lasers de classe B décalés des mêmes fréquences optiques et une barrette de photodétecteurs à une ou deux dimensions ;
- une barrette à une ou deux dimensions de lasers de classe B décalés par différentes fréquences optiques, et un photodétecteur suivi d'un démodulateur assurant une démodulation aux diverses fréquences.

EXPLICATION THÉORIQUE

Bien que ceci ne fasse pas partie intégrante de la présente invention, on va donner ci-après à titre d'indication divers calculs et équations permettant de mieux comprendre le phénomène mis en oeuvre par la présente invention. Toutefois, ceci ne doit pas être considéré comme une limitation de la présente invention.

Le principe de la méthode peut être compris en terme de modulation du gain du laser, modulation induite par la réinjection d'une partie du faisceau laser décalé en fréquence. Cette modulation du gain résulte d'une interaction entre le champ électrique $E_L$ oscillant dans la cavité du laser et du champ électrique réinjecté $E_{L,S}$ décalé d'une fréquence F.

Les équations les plus générales pour décrire la dynamique du système sont les équations du laser injecté (voir par exemple A.E. Siegmann, *Lasers,* ed. University Science Books, 1986).

Dans le cas où le laser est un laser de classe B, les équations se ramènent au système d'équations suivant :

$$\frac{dN}{dt} = \frac{N_0 - N}{T_1} - B|E_L|^2 N \tag{1}$$

$$\frac{dE_L}{dt} = \frac{BE_L N}{2} - \frac{E_L}{2T} + \frac{1}{T} E_{L,S} \cos\left(\Psi_L(t) + \Phi_{L,S}(t)\right) \tag{2}$$

$$\frac{d\Psi_L}{dt} = \omega_L - \omega_{L,S} - \frac{1}{T}\frac{E_{L,S}}{E_L} \sin\left(\Psi_L(t) + \Phi_{L,S}(t)\right) \tag{3}$$

où :

N est l'inversion de population,

$T_1$ est la durée de vie de l'inversion de population,

$\Psi_L$ est la différence de phase entre les champs électriques $E_L$ et $E_{L,S}$,

$\Phi_{L,S}$ est la fluctuation de phase de la lumière réinjectée dans la cavité,

$\omega_L$ est la fréquence optique du champ électrique $E_L$ dans la cavité,

$\omega_{L,S}$ est la fréquence optique du champ électrique $E_{L,S}$ réinjecté dans la cavité du laser,

T est la durée de vie des photons dans la cavité,

B est le coefficient d'Einstein.

**Ordre de grandeur**

Dans le système selon l'invention dans lequel la réinjection est faible et le rapport $m_S = 2E_{L,S}/E_L$ est faible, le second terme de l'équation (3) peut être négligé. Dans le cas d'un laser injecté par une source extérieure, cela revient à dire que le laser se trouve en-dehors de la zone d'accrochage définie par :

$$\frac{\Delta\omega}{2\pi} = \frac{1}{T}\frac{E_{L,S}}{E_L} .$$

En intégrant l'équation (3), on obtient

$$\Psi(t) = \left(\omega_L - \omega_{L,s}\right)t + C = 2\pi F t + C$$

où C est une constante d'intégration .

Le champ électrique réinjecté dans la cavité du laser s'obtient en écrivant :

$$E_{L.s}(t) = \frac{m_s}{2} E_L\left(t - t_d\right)$$

où $t_d$ est le temps d'aller retour de l'onde émise et réinjectée dans le laser. Ce temps $t_d$ étant court par rapport à l'inverse de la fréquence F, on néglige ce retard pur. Dans ces conditions, en posant l'intensité lumineuse dans la cavité laser $I_L = |E_L|^2$ et, en utilisant les variables réduites suivantes:

$\tau = t/T_1$ ; $n = BTN$ ; $\alpha = N_0 BT$

$s = BT_1 I$ ; $\gamma = T_1/T$,

on obtient le système d'équations suivant :

$$\frac{ds}{d\tau} = \gamma(n - 1) s + \gamma s m_s \cos\left(2\pi F t + \Phi_{L,s}(t)\right) \qquad (4)$$

$$\frac{dn}{d\tau} = \alpha - n - ns \qquad\qquad (5)$$

s décrit l'intensité du laser et n l'inversion de population. Ce système décrit bien un laser pour lequel le gain ou les pertes sont modulés.

En l'absence de réinjection, les valeurs stationnaires de l'intensité et de l'inversion de population sont respectivement :

$s_{st} = \alpha - 1$ et $n_{st} = 1$

Pour une très faible réinjection ($m_s \ll 1$) les équations (4) et (5) deviennent:

$$\frac{d\Delta n}{dt} = -\alpha\Delta n - \Delta s$$

$$\frac{d\Delta s}{dt} = \gamma s_{st} \Delta n + \gamma m_s s_{st} \cos\left(2\pi F t + \Phi_{L.s}(t)\right)$$

où $\Delta n$ et $\Delta s$ sont respectivement la variation de l'inversion de population et de l'intensité lumineuse au voisinage des valeurs stationnaires $n_{st}$ et $s_{st}$.

En éliminant l'inversion de population, on obtient l'équation qui décrit la modulation de l'intensité lumineuse émise par le laser

$$\frac{d^2\Delta s}{dt^2} + \alpha \frac{d\Delta s}{dt} + \gamma(\alpha - 1)\Delta s = \gamma(\alpha - 1)m_s\left[\alpha \cos\left(2\pi F t + \Phi_{L.s}\right) - 2\pi F \sin\left(2\pi F t + \Phi_{L.s}\right)\right]$$

La résolution de cette équation donne l'expression de l'amplitude de la modulation de l'intensité lumineuse émise par le laser réinjecté en fonction du décalage de fréquence F.

$$\left|\Delta s(\Omega)\right| = \frac{\sqrt{\Omega^2 + \alpha^2}}{\sqrt{\left(\omega_0^2 - \Omega^2\right) + \alpha^2\Omega^2}} \gamma(\alpha - 1)m_s$$

avec $\Omega = 2\pi F$ et $\omega_0^2 = \gamma(\alpha - 1)$.

Cette fonction a une résonance pour

$$F = \frac{\sqrt{\gamma(\alpha - 1)}}{2\pi} \ .$$

Le taux de modulation de la lumière passe alors par un maximum qui est

$$\frac{\left|\Delta s\left(\Omega = \omega_0\right)\right|}{s_{st}} = \frac{\sqrt{\omega_0^2 + \alpha^2}}{\alpha\omega_0} \gamma m_s \approx \frac{\gamma}{\alpha} m_s \ .$$

Ce signal de modulation est de l'ordre de $10^3$ fois plus important que pour le signal qui est obtenu à l'aide d'une détection hétérodyne classique (sans amplification par le laser) dans le cas où le laser est une diode laser, et de $10^6$ pour un laser à solide du type microlaser. Ce sont ces coefficients d'amplification très élevés ($10^3$ à $10^6$) qui font l'intérêt du système selon l'invention.

## Revendications

1. Détecteur optique **caractérisé en ce qu'**il comprend :

   une source laser (1) de classe B émettant un faisceau (3) à une première fréquence optique ;
   un moyen (4) interagissant avec le faisceau (3) pour fournir un rayonnement (5) à fréquence optique modifiée, le décalage entre la première fréquence et la fréquence modifiée étant voisin d'une fréquence de relaxation du laser ;
   un moyen (6) pour irradier une zone choisie d'un milieu à étudier par le rayonnement à la fréquence modifiée ;
   un moyen (6 ; 6', 12") pour injecter dans le laser de la lumière renvoyée par la zone choisie ; et
   un moyen (9, 14, 15, 16) pour détecter la perturbation apportée à l'émission laser par la lumière réinjectée.

2. Détecteur optique selon la revendication 1, **caractérisé en ce qu'**il comprend des moyens de balayage de la zone à étudier.

3. Détecteur optique selon la revendication 1, **caractérisé en ce qu'**il comprend des moyens de balayage en fréquence du rayonnement émis par le laser.

4. Détecteur optique selon la revendication 1, **caractérisé en ce que** le moyen d'irradiation (6) est constitué d'un objectif.

5. Détecteur optique selon la revendication 1, **caractérisé en ce que** le moyen de détection comprend un photodétecteur (9) suivi d'un système à détection synchrone (15).

6. Détecteur optique selon la revendication 1, **caractérisé en ce que** le moyen (4) pour fournir un rayonnement à fréquence optique modifiée consiste en un milieu à effet électro-optique ou acousto-optique excité par un oscillateur à une fréquence correspondant à la différence entre la fréquence optique modifiée et la première fréquence optique ou un de ses sous-multiples.

## Claims

1. An optical sensor, **characterized in that** it includes:

   a class B laser source (1) emitting a beam (3) at a first optical frequency;
   means (4) interacting with the beam (3) to provide a radiation (5) at a modified optical frequency, the shifting between the first frequency and the modified frequency being close to a relaxation frequency of the laser;
   means (6) for irradiating a selected area of a medium to be studied with the radiation at the modified frequency;
   means (6; 6', 12") for injecting into the laser light sent back by the selected area; and
   means (9, 14, 15, 16) for detecting the disturbance brought to the laser emission by the reinjected light.

**2.** The optical sensor of claim 1, **characterized in that** it includes means for scanning the area to be studied.

**3.** The optical sensor of claim 1, **characterized in that** it includes means for scanning the frequency of the radiation emitted by the laser.

**4.** The optical sensor of claim 1, **characterized in that** the irradiation means (6) are formed of a lens.

**5.** The optical sensor of claim 1, **characterized in that** the detection means include a photodetector (9) followed by a synchronous detection system (15).

**6.** The optical sensor of claim 1, **characterized in that** the means (4) for providing a radiation at a modified optical frequency consist of a medium having an electro-optical or acousto-optical effect excited by an oscillator at a frequency corresponding to the difference between the modified optical frequency and the first optical frequency or one of its sub-multiples.

**Patentansprüche**

**1.** Optischer Detektor **dadurch gekennzeichnet, dass** er Folgendes aufweist:

eine Laserquelle (1) der Klasse B, die einen Strahl (3) bei einer ersten optischen Frequenz emittiert;
Mittel (4), die mit dem Strahl (3) wechselwirken, zum Vorsehen einer Strahlung (5) bei einer modifizierten optischen Frequenz, wobei die Verschiebung zwischen der ersten Frequenz und der modifizieren Frequenz benachbart bzw. nahe zur Relaxationsfrequenz des Lasers ist;
Mittel (6) zum Bestrahlen eines ausgewählten Bereichs eines zu untersuchenden Mediums mit der Strahlung bei der modifizierten Frequenz;
Mittel (6; 6', 12") zum Injizieren von durch den ausgewählten Bereich zurückgeworfenen Lichts in den Laser; und
Mittel (9, 14 , 15, 16) zum Detektieren der Störung, die in die Laseremission durch das re-injizierte Licht eingebracht wird.

**2.** Optischer Detektor nach Anspruch 1, **dadurch gekennzeichnet, dass** er Mittel für das Abtasten bzw. Scannen des zu untersuchenden Bereichs aufweist.

**3.** Optischer Detektor nach Anspruch 1, **dadurch gekennzeichnet, dass** er Mittel für das Abtasten bzw. Scannen der Frequenz der durch den Laser emittierten Strahlung aufweist.

**4.** Optischer Detektor nach Anspruch 1, **dadurch gekennzeichnet, dass** die Bestrahlungsmittel (6) durch eine Linse ausgebildet sind.

**5.** Optischer Detektor nach Anspruch 1, **dadurch gekennzeichnet, dass** die Detektionsmittel einen Photodetektor (9) gefolgt durch ein synchrones Detektionssystem (15) aufweisen.

**6.** Optischer Detektor nach Anspruch 1, **dadurch gekennzeichnet, dass** die Mittel (4) zum Vorsehen einer Strahlung bei einer modifizierten optischen Sequenz aus einem Medium geformt sind mit einem elektro-optischen oder akust-optischen Effekt erregt durch einen Oszillator bei einer Frequenz, die dem Unterschied zwischen der modifizierten optischen Frequenz und der ersten optischen Frequenz oder einer ihrer Sub-Vielfachen entspricht.

EP 1 019 704 B1

Fig 1

Fig 2

8

Fig 3